# EUROPEAN PATENT APPLICATION

(11) **EP 2 216 681 A2**
(43) Date of publication of application: **11.08.2010**
(21) Application number: 10152005.4
(22) Date of filing: 28.01.2010
(51) Int. Cl.: G03F 7/00

(54) **Production of a surface relief on a substrate**

(30) Priority: 05.02.2009 GB 0901958
(71) Applicant: API Group PLC, Poynton Industrial Estate Poynton, Cheshire SK12 1ND (GB)
(72) Inventor: Done, Stephen, Quorn, Leicestershire LE12 8UX (GB); Carpenter, Phil, Gloucester, GL50 3RR (GB)
(74) Representative: Slingsby, Philip Roy

(57) **Abstract**

A method for producing a patterned surface relief on a substrate, the method comprising the steps of depositing a curable resin on to the substrate; pressing the surface of a first shim in to the resin, the surface of the first shim having an inverse impression profile of a first surface relief; curing the resin within the region pressed by the first shim; and removing the first shim from the resin; wherein one or both of the depositing and curing steps are performed on a first selected area within the region pressed by the first shim such that the surface relief in the resin is formed only within the said first selected area of the said region.

## Description

### FIELD OF INVENTION

The present invention relates to the production of a patterned surface relief on a substrate using a curable resin that is cured within certain defined regions.

### BACKGROUND

Holograms or diffractive optical structures are used, for example, on credit cards and packaging as a way of identifying that the underlying item is genuine, and/or to provide a pleasing visual effect on the surface of an item. These diffractive optical structures can be copied multiple times by using a stamp having a surface relief. Other optical structures such as Fresnel lenses, optical whites, and "smooth surfaces" that can have a mirror like appearance can also be copied multiple times by using a stamp having a surface relief.

A known technique for the production of a patterned surface relief is discussed in CH697447. This document describes using a substrate with a surface relief on one surface. The surface relief is then coated with a photoresist and depending on whether the photoresist is a positive or negative photoresist certain areas of the photoresist are then exposed. The exposed or unexposed regions of the photoresist, depending on the type of photoresist used can then be removed from the surface relief. In one embodiment, the surface relief is then removed in the regions exposed by the removal of the photoresist. This then creates the patterned surface relief which can be used, for example, in the production of hot stamp foils.

In CH697447 the pattern of the surface relief can be altered by changing the regions that are exposed or unexposed. For example, this allows for specific lettering to be produced with the surface relief inside the boundary of the letters.

It would be desirable to have a method that can enable the construction of a patterned surface relief whereby the combination of surface relief structures and pattern in which they are configured can be selected at the time of production of the patterned surface relief that can then be used, for example, to emboss surfaces and/or for stamping (for example hot stamping) of foils.

### SUMMARY OF THE INVENTION

According to a one aspect of the present invention there is provided a method for producing a patterned surface relief on a substrate, the method comprising the steps of: depositing a curable resin on to the substrate; pressing the surface of a first shim in to the resin, the surface of the first shim having an inverse profile of a first surface relief; curing the resin within the region pressed by the first shim; and removing the first shim from the resin; wherein one or both of the depositing and curing steps are performed on a first selected area within the region pressed by the first shim such that the surface relief in the resin is formed only within the said first selected area of the said region. Optionally, the curing of the first selected area may be defined by the use of an optical mask.

After the previous method steps of one aspect of the invention the method may further comprise the steps of: repositioning the substrate in a lateral direction relative to the first shim; and repeating the previous method steps.

After the previous method steps of one aspect of the invention the method may further comprise the steps of: pressing the surface of a second shim in to the resin, the surface of the second shim having an inverse profile of a second surface relief; curing the resin within a second selected area of the region pressed by the second shim; and removing the second shim from the curable resin. Before the step of pressing the surface of a second shim in to the resin, the method may further comprise the step of repositioning the substrate in a lateral direction relative to the second shim. The second selected area may be the same as the first selected area. Optionally, the curing of the first selected area may be defined by the use of an optical mask.

After the previous method steps of one aspect of the invention the method may further comprise the steps of: pressing the surface of the first shim in to the resin; curing the resin within a second selected area of the region pressed by the first shim; and removing the second shim from the curable resin.

The curable resin may be a UV curable resin and the step of curing the resin comprises exposing the UV curable resin to a pattern of UV light. The pattern of UV light may be formed using a mask placed between a UV light source and the UV curable resin. The mask may be formed using a liquid crystal display.

The method may further comprise the step of: washing the substrate with a solvent capable of removing the resin that is not cured. The method may further comprise the step of: applying a metal coating to the surface of the substrate comprising the surface relief. The method may further comprise the step of: applying a hard coating to the surface of the substrate comprising the surface relief.

### BRIEF DESCRIPTION OF THE DRAWINGS

Embodiments of the invention will now be described, by way of example only, with reference to the accompanying drawings in which:
Figure 1 shows the first group of steps of a preferred embodiment of the invention.
Figure 2 shows the second group of steps of a preferred embodiment of the invention.
Figure 3 shows the third group of steps of a preferred embodiment of the invention.
Figure 4 shows examples of the surface reliefs used in a preferred embodiment of the invention.
Figure 5 shows examples of the masks used in a preferred embodiment of the invention.
Figure 6 shows examples of results of combinations of the processes used in a preferred embodiment of the invention.

### DETAILED DESCRIPTION OF PREFERRED EMBODIMENTS

The method described below provides a way of producing a patterned surface relief on a substrate by curing a resin in areas defined by the pattern whilst a shim with a surface relief is pressed in to the resin. Multiple impressions of the one surface relief on a shim may be taken in the same or differing patterns or multiple impressions of more than one shim with different surface relief designs may be used. A combination of these two processes may also be used to produce the final design. The produced patterned surface relief on the substrate can then go on to produce an embossing shim used in the production of diffractive and non-diffractive optical structures.

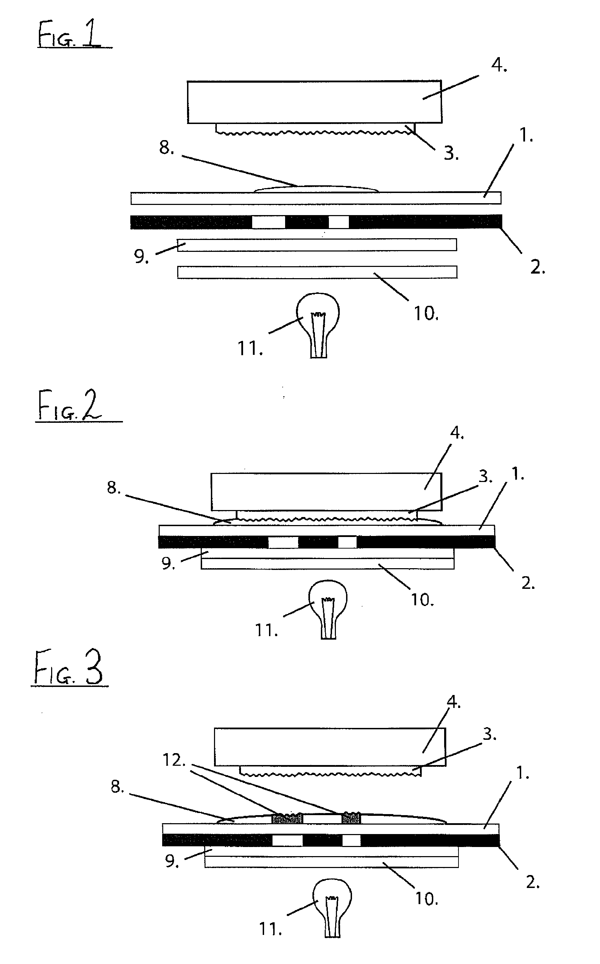

Figure 1 shows the initial position of the elements that could be used for the production of the patterned surface relief. The substrate 1 is loaded in to a frame on a pressing machine. The substrate 1 could, for example, be a 250 micron print treated polyester. Alternatively, other materials than a polyester could be used for the substrate 1. Also, other thicknesses of substrate could equally be used as required.

A photographically produced mask 2 may be loaded in to the machine between the substrate 1 and a shutter system 10. The shutter system 10 allows light through when open. The mask 2 determines the pattern of light that will be allowed to reach the substrate 1. In the example given in Figure 1 the black parts of the mask 2 are non-transmissive and the white parts are transmissive. A window 9 may also be present between the shutter system 10 and either the mask 2 or the substrate 1 to provide a support for the substrate 1 or the substrate 1 and mask 2. This window 9 may be made of quartz.

A light source 11 is positioned such that when switched on and the shutter system 10 is open, light can pass though the shutter system 10 to the substrate 1. The transmissive parts of the mask 2 that may be present between the shutter system 10 and the substrate 1 allow light to pass through to the substrate 1. The light source 11 used in the machine may be a UV light source or any other source capable of providing radiation suitable for curing the resin 8. For example, the light source 11 may instead be an electron beam source and the resin capable of being cured when exposed to electrons. Alternatively, nuclear curing of the resin may be used. In the cases of electron beam curing and nuclear curing the mask 2 would need to be altered accordingly such that the beams are blocked in the correct areas.

A measured amount of curable resin 8 is deposited on to the substrate 1. This measured amount of curable resin may mean that the whole of the substrate 1 is covered in resin. Alternatively the deposition of the resin 8 may be controlled such that it is only present in the areas of the substrate 1 that are required to have a surface relief. Another option is that the deposition of the measured amount of curable resin 8 covers an area large enough to cover at least the transmissive areas of the mask 2. The resin can then be cured in the transmissive areas of the mask 2 in a later step.

If a UV light source is used for the light source 11 then the curable resin 8 may be a resin that is curable under exposure to UV light, in other words a UV curable resin 8. Alternatively, the resin 8 may be curable using other types of radiation.

In the area containing the mask 2 and the deposited resin 8 the head 4 of the machine is also positioned so that it can press on the deposited resin 8. The head 4 has a shim 3 mounted to it. The inverse of the first surface relief 13 is present on the surface of the shim 3. This surface of the shim 3 being the one facing away from the head 4 that the shim 3 is mounted to. The shim 3 could, for example, be manufactured from nickel or an alternate material that allows the required surface relief to be produced in the shim 3.

As shown in Figure 2, after the deposition of the resin 8 on to the substrate, the head 4 containing the shim 3 can be moved towards the substrate 1 such that the inverse of the first surface relief 13 present on the shim 3 is pressed in to the resin 8. The head 4 is moved towards the substrate 1 by a set distance so that the pressing of the resin 8 causes the resin 8 to spread in to a thin film. Alternatively, the head 4 is moved towards the substrate 1 until a set force is applied on the resin 8. The set force being such that the resin 8 spreads in to a thin film of the required thickness. The thickness of the resin film is typically 2-3 microns; however the layer of resin 8 could be pressed to be thicker or thinner than this range during the pressing step if required. For example, a thickness of 2-3 microns may be required in the production of a diffractive optical structure; however other thicknesses may be needed to produce Fresnel lenses, optical whites and/or "smooth surfaces".

When the layer of resin 8 has been pressed to the required thickness a predetermined period of time or wait time may elapse prior to the curing of the resin 8. This wait time may be present to allow the resin to flow in to the profile of the surface relief so that the correct surface relief will be present in the resin after curing. The wait time can also help in the evacuation of air bubbles present in the resin. The resin is then cured by exposing the resin to light by opening the shutter system 10 to allow light to pass from the light source 11 through the substrate to the resin 8. The curing may occur by opening and closing the shutter system 10 once and so in one exposure. Alternatively, multiple exposures of the resin 8 may be used to cure the resin 8 by opening and closing the shutter system 10 multiple times.

If a mask 2 has been used in between the shutter system and the substrate then the areas of cured resin 12 will only be in the regions in which light was allowed to be transmitted by the mask 2. Alternatively, if the resin 8 was only applied in particular areas of the substrate then only these areas would now have cured resin present.

As shown in Figure 3, after the curing of the resin 8, the head 4 and the shim 3 connected to the head 4 can be moved away from the substrate 1 and resin 8. This leaves behind the areas of cured resin 12 and curable resin 8 on the substrate 1. The areas of cured resin 12 during the curing process are adhered to the substrate 1. On the surface facing away from the substrate of these areas of cured resin 12 the first surface relief 13 that was in inverse form on the surface of the shim 3 is now present.

If only one pattern using a single surface relief was intended to be generated on the substrate 1 then the curable resin 8 that remains on the substrate 1 can be washed off using a suitable solvent. The substrate 1 can be removed from the machine prior to the washing using a suitable solvent. This leaves only the areas of cured resin 12 comprising the first surface pattern impression on the substrate 1.

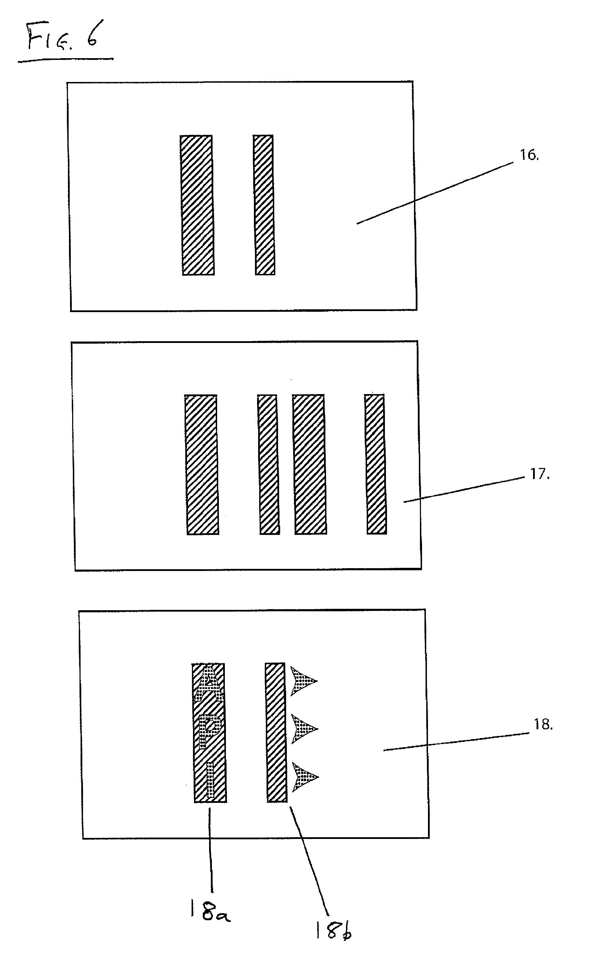

By way of example, the result of taking one impression of the inverse of the first surface relief using mask 2 to cure the resin 8 is shown in Figure 6 as substrate 16. The hatched areas show the cured resin 12 with the first surface relief in the positions where the mask 2 is transmissive.

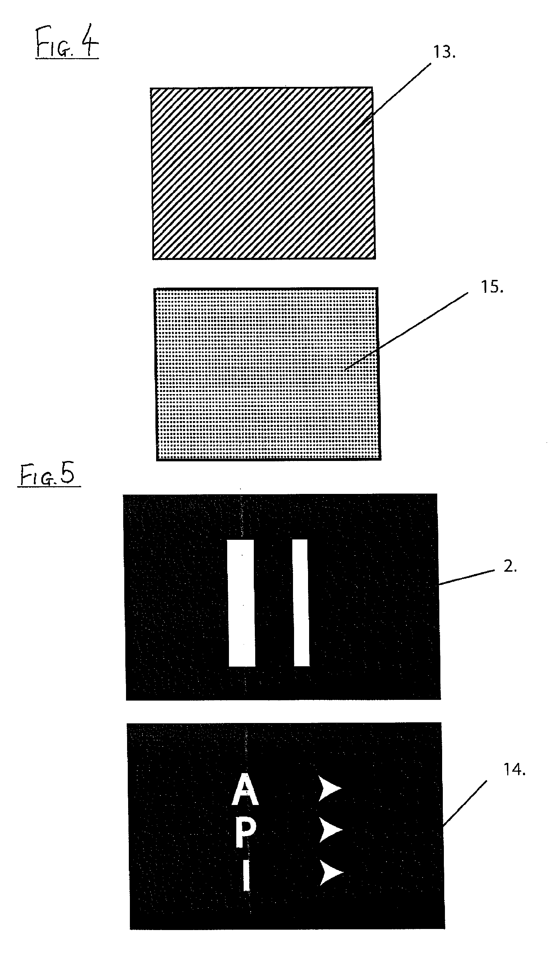

Alternatively, after the first curing and removal of the shim 3 from the resin, the substrate 1 could be repositioned relative to the mask 2 and a duplicate structure to the first cured resin 12 can be created by following the same process steps as for creating the first cured resin 12. This process may be repeated any number of times to create the required pattern of surface relief regions on the substrate 1. After the numerous pressing and curing steps have been completed the remaining curable (non-cured) resin 8 can be removed by washing with a suitable solvent. An example of this process is substrate 17 in Figure 6. In this example two areas of cured resin have been created using the mask 2 shown in Figure 5 and first surface relief 13 in Figure 4. By creating multiple copies of the same pattern of surface relief on the substrate, the substrate and patterned surface relief could be used to produce multiple optical structures at one time. Alternatively the multiple copies of the same pattern of surface relief could form a repeating pattern in the optical structure if required.

In another example, after the shim 3 comprising the inverse of the first surface relief 13 has been used to press the resin 8 during the curing step or steps a second shim may be installed in or on the head 4 instead of the first shim 3. This second shim can, for example, have the inverse of a second surface relief 15, as shown in Figure 4, on the side facing the substrate 1. The resin 8 can then be pressed using this second shim and either cured using the same mask in a different area of the substrate as when the resin 8 was pressed using the first shim, or using a second mask 14, for example as shown in Figure 5.

In the case where the same mask is used the substrate 1 could be moved laterally relative to the head 4 to allow the resin 8 to be cured in a different area to that cured when the first shim 3 was pressed in to the resin 8. As an example, this could allow multiple versions of a customer's logo to be produced, each logo being formed by a different diffractive optical pattern, or hologram. This can increase the complexity in copying the whole optical pattern, and/or make the optical pattern more interesting to look at.

In the case that a different mask is used when the resin 8 is pressed using the second shim a combination of curing the resin being pressed by the second shim in an area already containing the first cured resin and an area not containing the first cured resin could be achieved. This combination allows for the production of multiple diffractive optical patterns, possibly with one optical pattern placed on top of another optical pattern so as to nullify, fill in or wipe out the pattern below, without the creation of a customised surface relief on a shim having the specific pattern required. A number of stock shims can be created with a different surface relief on each one. At the time of fabrication of the specific patterned surface relief the configuration of these each different surface relief can be decided. This allows for the selection of a pattern without the excess cost associated with the production of a fully customised shim. Alternatively, a custom shim could be used, with various patterns made using this custom shim by altering the mask used.

A patterned surface relief containing the first and second surface relief is shown as an example as substrate 18 in Figure 6. On this substrate is a rectangle of the first surface relief 13 with the letters API within the rectangle using the second surface relief 15, this is indicated as 18a. Also present on substrate 18 is 18b which has a smaller rectangle produced using the first surface relief 13 with triangles produced using the second surface relief 15 beside the smaller rectangle. This gives one example of a pattern that could be created to match a client's specification.

After washing off of the curable/uncured resin 8 from the substrate 1 the substrate is can be dried. The substrate 1 with the patterned surface relief is then sprayed with silver, or another seed metal, prior to being electroplated. The electroplating step produces an embossing shim that can be used in the production of, for example, diffractive optical structures, Fresnel lenses, optical whites and "smooth surfaces". Alternatively, other methods of hardening the surface of the patterned surface relief may be used. For example, other methods of metallisation may be used, or a thin layer of ceramic could be applied to the surface of the patterned surface relief. In another embodiment the patterned surface relief could be made reflective, for example, by spraying the surface with metal, and then the patterned surface relief can be used directly as the optical structure.

In an alternate embodiment, an LCD possibly incorporating a polarizer between the LCD and the substrate may be used instead of a mask. The image displayed on the LCD in combination with the polarizer alters the areas in which light can pass through to the substrate from the light source. The use of an LCD instead of a mask allows the pattern of the surface relief to be created at the time of production. For example, a client could supply a graphic file containing the various masks to be used in production. This would avoid the need to produce a custom mask or masks before the production of the patterned surface relief structure. The LCD can be put in to the correct state prior to the process of pressing and curing to provide the needed pattern in the surface relief being pressed.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features. In view of the foregoing description it will be evident to a person skilled in the art that various modifications may be made within the scope of the invention.

## Claims

1. A method for producing a patterned surface relief on a substrate, the method comprising the steps of:
depositing a curable resin on to the substrate;
pressing the surface of a first shim in to the resin, the surface of the first shim having an inverse profile of a first surface relief;
curing the resin within the region pressed by the first shim; and
removing the first shim from the resin;
wherein one or both of the depositing and curing steps are performed on a first selected area within the region pressed by the first shim such that the surface relief in the resin is formed only within the said first selected area of the said region.

2. A method as claimed in claim 1, wherein after the method steps of claim 1 the method further comprises the steps of:
repositioning the substrate in a lateral direction relative to the first shim; and
repeating the method steps of claim 1.

3. A method as claimed in claim 1, wherein after the method steps of claim 1 the method further comprises the steps of:
pressing the surface of a second shim in to the resin, the surface of the second shim having an inverse profile of a second surface relief;
curing the resin within a second selected area of the region pressed by the second shim; and
removing the second shim from the curable resin.

4. A method as claimed in claim 3, wherein before the step of pressing the surface of a second shim in to the resin, the method further comprises the step of repositioning the substrate in a lateral direction relative to the second shim.

5. A method as claimed in claim 4, wherein the second selected area is the same as the first selected area.

6. A method as claimed in claim 1, wherein after the method steps of claim 1 the method further comprises the steps of:
pressing the surface of the first shim in to the resin;
curing the resin within a second selected area of the region pressed by the first shim; and
removing the second shim from the curable resin.

7. A method as claimed in any preceding claim, wherein the curable resin is a UV curable resin and the step of curing the resin comprises exposing the UV curable resin to a pattern of UV light.

8. A method as claimed in claim 7, wherein the pattern of UV light is formed using a mask placed between a UV light source and the UV curable resin.

9. A method as claimed in claim 8, wherein the mask is formed using a liquid crystal display.

10. A method as claimed in any preceding claim, wherein the method further comprises the step of:
washing the substrate with a solvent capable of removing the resin that is not cured.

11. A method as claimed in any preceding claim, wherein the method further comprises the step of:
applying a metal coating to the surface of the substrate comprising the surface relief.

12. A method as claimed in any of claims 1 to 10, wherein the method further comprises the step of:
applying a hard coating to the surface of the substrate comprising the surface relief.
